(19) Europäisches Patentamt
European Patent Office
Office européen des brevets

(11) EP 2 678 698 B1

# (12) EUROPÄISCHE PATENTSCHRIFT

(45) Veröffentlichungstag und Bekanntmachung des Hinweises auf die Patenterteilung:
**06.04.2016 Patentblatt 2016/14**

(21) Anmeldenummer: **12701322.5**

(22) Anmeldetag: **05.01.2012**

(51) Int Cl.:
***G01R 29/26*** (2006.01)

(86) Internationale Anmeldenummer:
**PCT/EP2012/050118**

(87) Internationale Veröffentlichungsnummer:
**WO 2012/113585 (30.08.2012 Gazette 2012/35)**

## (54) VERFAHREN UND VORRICHTUNG ZUR MESSUNG DES PHASENRAUSCH-SPEKTRUMS EINES GEPULSTEN SINUSSIGNALS

METHOD AND DEVICE FOR MEASURING THE PHASE NOISE SPECTRUM OF A PULSED SINUSOIDAL SIGNAL

PROCÉDÉ ET DISPOSITIF DE MESURE DU SPECTRE DE BRUIT DE PHASE D'UN SIGNAL SINUSOÏDAL PULSÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.02.2011 DE 102011004572**

(43) Veröffentlichungstag der Anmeldung:
**01.01.2014 Patentblatt 2014/01**

(73) Patentinhaber: **Rohde & Schwarz GmbH & Co. KG**
**81671 München (DE)**

(72) Erfinder:
- **ECKERT, Hagen**
**86415 Mering (DE)**
- **WEISS, Martin**
**83607 Holzkirchen (DE)**
- **WENDLER, Wolfgang**
**82194 Gröbenzell (DE)**

(74) Vertreter: **Körfer, Thomas**
**Mitscherlich PartmbB**
**Patent- und Rechtsanwälte**
**Sonnenstrasse 33**
**80331 München (DE)**

(56) Entgegenhaltungen:
**EP-A1- 1 892 533**
**WO-A1-2008/110237**
**KR-A- 20030 044 105**
**US-A- 5 557 196**
**US-A1- 2010 080 274**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 678 698 B1

## Beschreibung

Die Erfindung betrifft ein Verfahren und eine Vorrichtung zur Messung des Phasenrausch-Spektrums eines gepulsten Sinussignals.

Die DE 10 2005 017 217 A1 offenbart ein Verfahren zur Messung des Phasenrauschens eines nicht gepulsten Sinussignals. Beispielsweise in der Radar-Technik werden bevorzugt gepulste Sinussignale verwendet. Hierzu werden von einem Oszillator ein hochfrequentes Sinussignal und von einem Puls-Generator ein niederfrequenteres Pulssignal erzeugt. Das hochfrequente Sinussignal wird in einem Puls-Modulator zur Erzeugung des gepulsten Sinussignals mit dem niederfrequenteren Pulssignal moduliert.

Fig. 1 zeigt eine bei der Anmelderin intern bisher verwendete Anordnung zum besseren Verständnis der erfindungsgemäßen Maßnahmen. Dies ist jedoch nicht öffentlich zugänglich geworden und somit kein Stand der Technik. In einer Signalquelle 1 wird ein gepulstes Sinussignal erzeugt, dessen Phasenrauschen zu ermitteln ist. Die Signalquelle 1 besteht aus einem Oszillator 2, der ein hochfrequentes Sinussignal generiert, einem Puls-Generator 3, der ein niederfrequenteres Pulssignal erzeugt, und einem Puls-Modulator 4, der das hochfrequente Sinussignal mit dem niederfrequenteren Pulssignal moduliert.

Das gepulste Sinussignal wird einem Eingang eines Phasen-Detektors 5, der als Mischer realisiert ist, zugeführt. Der andere Eingang des Phasen-Detektors 5 wird mit einem in einer Referenz-Quelle generierten Referenz-Signal beaufschlagt. Die Referenz-Quelle 6 ist analog zur Signalquelle aufgebaut und besteht aus einem in seiner Frequenz und Phase regelbaren Oszillator 7, der ein hochfrequentes Referenz-Sinussignal generiert, dem gleichen Puls-Generator 3, der das identische niederfrequente Pulssignal erzeugt, und einem Puls-Modulator 8, der das hochfrequente Referenz-Sinussignal mit dem niederfrequenteren Pulssignal moduliert. Die Frequenz- und Phasen-Regelung des in seiner Frequenz und Phase regelbaren Oszillators 7 erfolgt über eine PLL-Regelschleife bestehend aus einem PLL-Regler 9, der in Abhängigkeit des Ausgangssignals des Phasen-Detektors 5 ein Regler-Signal zur Ansteuerung des in seiner Frequenz und Phase regelbaren Oszillators 7 erzeugt, so dass die Trägerfrequenz des hochfrequenten gepulsten Sinussignals und des hochfrequenten Referenz-Sinussignals identisch sind und die Phasen des hochfrequenten gepulsten Sinussignals und des hochfrequenten Referenz-Sinussignals zueinander orthogonal sind.

Durch das Mischen des hochfrequenten gepulsten Sinussignals und des hochfrequenten Referenz-Sinussignals mit jeweils identischer Trägerfrequenz entsteht eine Signalkomponente bei der doppelten Trägerfrequenz, das durch ein dem Phasen-Detektor 5 nachfolgend geschaltetes Tiefpass-Filter 10 beseitigt wird, und eine Signalkomponente bei der Frequenz Null. Die Signalkomponente bei der Frequenz Null des Mischer-Ausgangssignals, die nur noch die Rauschsignalanteile des gepulsten Sinussignals enthält, wird zur Ermittlung des Phasenrauschens im gepulsten Sinussignal weiterverfolgt.

Die analoge Phasenregelung (Phase-Locked-Loop (PLL)) erfordert ein zeitaufwändiges Einfangen der Frequenz des von der Referenz-Quelle 6 erzeugten hochfrequenten Referenz-Sinussignals bezüglich der Frequenz des von der Signalquelle 1 erzeugten hochfrequenten gepulsten Sinussignals und eine Normalisierungs-Vormessung. Die Messzeit der Phasenrauschmessung verlängert sich durch diese Normalisierungs-Vormessung unnötig.

Hinzukommt, dass ein gepulstes Sinussignal u(t) mit überlagerten Rauschen gemäß Fig. 4A zu einem Spektrum U(f) gemäß Fig. 4B führt, das neben dem Rauschspektralanteil eine Vielzahl von Spektrallinien aufweist, die dem gepulsten sinusförmigen Nutzsignalanteil im Zeitbereich entsprechen. Für eine Analyse des Phasenrausch-Spektrums sind diese zum Nutzsignalanteil des zu vermessenden Signals gehörigen Spektrallinien störend.

KR 2003 0044 105 A und US 5,557,196 A offenbaren Verfahren und Vorrichtungen zur Messung des Phasenrausch-Spektrums gepulster Sinussignale.

Die Aufgabe der Erfindung ist es deshalb, ein Verfahren und eine Vorrichtung zur Phasenrauschmessung eines gepulsten Sinussignals zu schaffen, die einerseits eine minimale Messzeit aufweisen und andererseits von Nutzsignal-Spektralanteilen im Phasenrausch-Spektrum befreit sind.

Die Aufgabe wird durch ein Verfahren zur Messung des Phasenrausch-Spektrums eines gepulsten Sinussignals mit den Merkmalen des Patentanspruchs 1 und durch eine erfindungsgemäße Vorrichtung zur Messung des Phasenrausch-Spektrums eines gepulsten Sinussignals mit den Merkmalen des Patentanspruchs 7 gelöst. Vorteilhafte technische Weiterbildungen sind in den jeweils abhängigen Patentansprüchen aufgeführt.

Erfindungsgemäß wird die analoge Phasenrauschmessung mittels PLL-Regelkreis durch eine digitale Phasenrauschmessung ersetzt, bei der das gepulste Sinussignal nach seiner Erzeugung mittels Analog-Digital-Wandlung ins digitale Datenformat transformiert wird und mittels Quadratur-Mischung ins Basisband gemischt wird. Die Quadratur-Mischung erzeugt ein gepulstes Sinussignal im Basisband, das mit seiner Inphase- und Quadraturkomponente ein komplexes Basisbandsignal darstellt, von dem vergleichsweise einfach - beispielsweise mittels eines Cordinate-Rotation-Digital-Computer(Cordic)-Bausteins - die zugehörige Phase des gepulsten Sinussignals im Basisband ermittelt wird. Mittels diskreter Fourier-Transformation wird aus der Phase des gepulsten Sinussignals im Basisband das Phasenspektrum des gepulsten Sinussignals ermittelt. Durch Beseitigung der zum sinusförmigen Nutzsignal gehörigen Spektrallinien aus dem Phasenspektrum wird das Phasenrausch-Spektrum des gepulsten Sinussignals ermittelt.

Zusätzlich werden erfindungsgemäß nach der Quadraturmischung die Pulspausen aus dem gepulsten Sinussignal im Basisband entfernt. Auf diese Weise geht das gepulste Sinussignal in ein Sinussignal über, das lediglich an den Übergangsstellen der ursprünglichen Pulse u.U. Unstetigkeiten aufweist. Das zugehörige Spektrum und damit das Phasenrausch-Spektrum eines von Pulspausen befreiten gepulsten Sinussignals weist folglich nur noch die Spektrallinien bei der positiven und negativen Frequenz des Sinussignals, das Rauschspektrum des überlagerten Rauschsignals und Dirac-Impulse aufgrund von Unstetigkeiten im Signalverlauf des von Pulspausen befreiten gepulsten Sinussignals auf.

In einer ersten Ausführungsform der Erfindung werden die Pulspausen aus dem gepulsten Sinussignal im Basisband durch zeitliches Verschieben des Endes des jeweils vorausgehenden Pulses an den Beginn des jeweils nachfolgenden Pulses entfernt.

In einer zweiten Ausführungsform der Erfindung werden die Pulspausen aus dem gepulsten Sinussignal im Basisband entsprechend dem Verschiebungssatz der Spektraltransformationen durch eine der Zeitverschiebung der einzelnen Pulse entsprechende Phasenverschiebung der zu den einzelnen Pulsen jeweils gehörigen Spektren entfernt.

Dirac-Impulse im Phasenrausch-Spektrum aufgrund von Unstetigkeiten im Signalverlauf des von Pulspausen befreiten gepulsten Sinussignals werden in einer ersten Unterausführungsform der Erfindung identifiziert und durch Interpolation der jeweils benachbarten Spektralwerte des Phasenrausch-Spektrums aus dem Phasenrausch-Spektrum beseitigt.

In einer zweiten Unterausführungsform der Erfindung werden Dirac-Impulse im Phasenrausch-Spektrum aufgrund von Unstetigkeiten im Signalverlauf des von Pulspausen befreiten gepulsten Sinussignals dadurch eliminiert, dass der jeweils nachfolgende Puls des von Pulspausen befreiten gepulsten Sinussignals an seinem Beginn soweit verkürzt oder der jeweils vorausgehende Puls des von Pulspausen befreiten gepulsten Sinussignals an seinem Ende soweit verkürzt wird, bis die Phase am Beginn des jeweils nachfolgenden Pulses mit der Phase am Ende des jeweils vorausgehenden Pulses übereinstimmt und somit keine Unstetigkeit am Übergang zwischen jeweils zwei aufeinander folgenden Pulsen eines von Pulspausen befreiten gepulsten Sinussignals mehr entsteht. Ein von Pulspausen und von Unstetigkeiten an den Übergängen aufeinander folgender Pulse befreites Phasenrausch-Spektrum enthält auch keine Dirac-Impulse.

Zur Beseitigung von zusätzlichem Phasenrauschen, das in der Messsignal-Verarbeitungskette entsteht und sich dem Phasenrauschen des zu vermessenden gepulsten Sinussignals überlagert, wird das gepulste Sinussignal in ein erstes gepulstes Sinussignal und ein zum ersten gepulsten Sinussignal identisches zweites gepulstes Sinussignal geteilt. Das erste und zweite gepulste Sinussignal werden jeweils in einer separaten Signalverarbeitungskette analog-digital gewandelt, mittels Quadratur-Mischung ins Basisband gemischt. Die jeweils ermittelten Phasen des ersten und zweiten gepulsten Sinussignals im Basisband werden kreuzkorreliert und Fourier-transformiert. Das Ergebnis der Kreuzkorrelation enthält lediglich die zueinander korrelierten Nutzsignal- und Rauschsignalanteile des ursprünglich erzeugten gepulsten Sinussignals im ersten bzw. zweiten gepulsten Basisband-Sinussignal, während die nicht zueinander korrelierten Rauschanteile im ersten bzw. zweiten gepulsten Basisband-Sinussignal, die in den beiden Signalverarbeitungspfaden jeweils entstehen, entfernt sind.

Im Folgenden werden die Ausführungsformen und die Unterausführungsformen des erfindungsgemäßen Verfahrens und der erfindungsgemäßen Vorrichtung zur Messung des Phasenrausch-Spektrums eines gepulsten Sinussignals anhand der Zeichnung im Detail beispielhaft erläutert. Die Figuren der Zeichnung zeigen:

| | |
|---|---|
| Fig. 1 | ein Blockdiagramm einer bei der Anmelderin intern bisher verwendeten Vorrichtung zur Messung des Phasenrausch-Spektrums eines gepulsten Sinussignals, |
| Fig. 2A | ein Blockdiagramm einer ersten Ausführungsform einer erfindungsgemäßen Vorrichtung zur Messung des Phasenrausch-Spektrums eines gepulsten Sinussignals, |
| Fig. 2B | ein Blockdiagramm einer zweiten. Ausführungsform einer erfindungsgemäßen Vorrichtung zur Messung des Phasenrausch-Spektrums eines gepulsten Sinussignals, |
| Fig. 2C | ein Blockdiagramm einer dritten Ausführungsform einer erfindungsgemäßen Vorrichtung zur Messung des Phasenrausch-Spektrums eines gepulsten Sinussignals, |
| Fig. 3 | ein Zeitdiagramm der zeitverschobenen Pulse des gepulsten Sinussignals entsprechend der zweiten Ausführungsform der Erfindung, |
| Fig. 4A,4B | ein Zeitdiagramm mit einem gepulsten Sinussignal und ein Frequenzdiagramm mit einem zugehörigen Spektrum, |

Fig. 5A,5B ein Zeitdiagramm mit einer ersten Unterausführungsform eines erfindungsgemäß von Pulspausen befreiten, gepulsten Sinussignals und ein Frequenzdiagramm mit einem zugehörigen Spektrum,

Fig. 6A,6B ein Zeitdiagramm mit einer zweiten Unterausführungsform eines erfindungsgemäß von Pulspausen befreiten, gepulsten Sinussignals und ein Frequenzdiagramm mit einem zugehörigen Spektrum,

Fig. 7A ein Flussdiagramm einer ersten Ausführungsform eines erfindungsgemäßen Verfahrens zur Messung des Phasenrausch-Spektrums eines gepulsten Sinussignals

Fig. 7B ein Flussdiagramm einer zweiten Ausführungsform eines erfindungsgemäßen Verfahrens zur Messung des Phasenrausch-Spektrums eines gepulsten Sinussignals, und

Fig. 7C ein Flussdiagramm einer dritten Ausführungsform eines erfindungsgemäßen Verfahrens zur Messung des Phasenrausch-Spektrums eines gepulsten Sinussignals

Im Folgenden wird die erste Ausführungsform der erfindungsgemäßen Vorrichtung anhand des Blockdiagramms in Fig. 2A und des erfindungsgemäßen Verfahrens anhand des Flussdiagramms in Fig. 7A erläutert.

Im ersten Verfahrensschritt S10 wird in einer Signalquelle 1 ein gepulstes Sinussignal gemäß Fig. 4A generiert. Hierzu wird in einem Oszillator 2 ein hochfrequentes Sinussignal erzeugt. Dieses hochfrequente Sinussignal wird zur Erzeugung des gepulsten Sinussignals anschließend in einem Puls-Modulator 4 mit einem in einem Puls-Generator 3 generierten relativ niederfrequenteren Pulssignal (entspricht dem gestrichelten Signalverlauf in Fig. 4A) moduliert.

Im nächsten Verfahrensschritt S20 wird das gepulste Sinussignal in einem Verstärker 11 hinsichtlich seines Signalpegels an den Eingangssignalpegelbereich eines nachfolgenden Analog-Digital-Wandlers 12 angepasst. Zusätzlich erfolgt in Verfahrensschritt S20 eine Tiefpass-Filterung des gepulsten Sinussignals in einem Tiefpass-Filter 13. Die Tiefpass-Filterung bewirkt eine Bandbegrenzung des gepulsten Sinussignals angepasst an die Abtast-Frequenz des nachfolgenden Analog-Digital-Wandlers zur Vermeidung von Aliasing im Spektrum des digitalen gepulsten Sinussignals.

Im nächsten Verfahrensschritt S30 wird das hochfrequente gepulste Sinussignal in eine Zwischenfrequenzlage gemischt. Hierzu wird das hochfrequente gepulste Sinussignal in einem Mischer 14 mit einem in einem lokalen Oszillator 15 generierten Mischersignal gemischt. Die Mischung des gepulsten Sinussignals in die Zwischenfrequenzlage kann entfallen, wenn sich das gepulste Sinussignal bereits in einer (Zwischen)-Frequenzlage befindet, in der eine Analog-Digital-Wandlung bereits durchführbar bzw. sinnvoll ist.

Der nächste Verfahrensschritt S40 beinhaltet die Analog-Digital-Wandlung des analogen gepulsten Sinussignals in ein korrespondierendes digitales gepulstes Sinussignal in einem Analog-Digital-Wandler 12 im Zwischenfrequenz-Band.

Im darauffolgenden Verfahrensschritt S50 erfolgt eine Quadratur-Mischung des digitalen gepulsten Sinussignals vom Zwischenfrequenzband ins Basisband mittels eines Quadraturmischers 16. Der Quadratur-Mischer 16 liefert die beiden kartesischen Komponenten - Inphasekomponente I und Quadraturkomponente Q - eines komplexen gepulsten Sinussignals im Basisband.

Der nächste Verfahrensschritt S60 führt die erfindungsgemäße Entfernung von Pulspausen im gepulsten Sinussignal im Basisband mittels einer Einheit 27 zum Entfernen von Pulspausen aus dem gepulsten Sinussignal durch. Hierzu werden von einer zur Einheit 27 zum Entfernen von Pulspausen aus dem gepulsten Sinussignal gehörigen Einheit 17 zum Zusammenfügen von in Pulsen auftretenden Signalwerten die Zeitintervalle der Pulspausen anhand eines Schwellwertvergleichs der Abtastwerte der Inphase- und Quadraturkomponenten des komplexen gepulsten Sinussignals im Basisband mit einem geeignet gewählten Schwellwert identifiziert und einzig die in den Pulsen auftretenden Abtastwerte der Inphase- und Quadraturkomponenten des komplexen gepulsten Sinussignals im Basisband in einem zur Einheit 27 zum Entfernen von Pulspausen aus dem gepulsten Sinussignal gehörigen Ringpuffer 18 abgespeichert.

Auf diese Weise werden die Abtastwerte der Inphase-Komponente I und der Quadratur-Komponente Q des komplexen gepulsten Sinussignals im Basisband im Ringpuffer 18 in den einzelnen aufeinander folgenden Phasen eines Pulses ohne Lücke und damit ohne Pulspause aneinander gereiht. Das Auslesen der ohne Pulspause aneinander gereihten Abtastwerte der Inphase-Komponente I' und der Quadratur-Komponente Q' des komplexen gepulsten Sinussignals im Basisband erfolgt mit einer geeignet gewählten Abtastfrequenz.

In einer ersten Unterausführungsform der erfindungsgemäßen Entfernung von Pulspausen aus dem gepulsten Sinussignal u(t) werden die einzelnen Pulse des gepulsten Sinussignals gemäß Fig. 5A direkt ohne Verkürzung der Pulse zu einem von Pulspausen befreiten gepulsten Sinussignal zusammengefügt. Dabei kann es vorkommen, dass die Phase des jeweils vorausgehenden Pulses nicht mit der Phase des jeweils nachfolgenden Pulses im von Pulspausen befreiten gepulsten Sinussignal u(t)' übereinstimmt und eine Unstetigkeit im Signalverlauf des von Pulspausen befreiten gepulsten Sinussignals u(t)' entsteht. Im zugehörigen Spektrum U(f)' in Fig. 5B führen diese periodisch in Zyklus einer Pulsdauer auftretenden Unstetigkeiten im Signalverlauf des von Pulspausen befreiten gepulsten Sinussignals u(t)' zu einem Dirac-Stoß 20" bei der Frequenz der Periodizität der aneinander gereihten Pulse. Neben dem auf die Unstetigkeiten zurückzuführenden Dirac-Stoß 20" sind im Spektrum U(f)’ des von Pulspausen befreiten gepulsten Sinussignals u(t)’ auch die auf das Sinussignal zurückgehende Spektrallinie 19" bei der Frequenz des Sinussignals und das Rauschspektrum des dem gepulsten Sinussignal überlagerten Rauschsignalanteils zu erkennen.

In einer zweiten Unterausführungsform der erfindungsgemäßen Entfernung von Pulspausen aus dem gepulsten Sinussignal u(t) werden die jeweils nachfolgenden Pulse des gepulsten Sinussignals im Basisband am Pulsbeginn in einer in Fig. 2 nicht dargestellten Funktionseinheit soweit verkürzt, dass die Phase des jeweils vorausgehenden Pulses mit der Phase des jeweils nachfolgenden Pulses im von Pulspausen befreiten gepulsten Sinussignal u(t)" übereinstimmt und gemäß Fig. 6A keine Unstetigkeit im Signalverlauf des von Pulspausen befreiten gepulsten Sinussignals u(t)" entsteht. Im zugehörigen Spektrum U(f)’ in Fig. 6B ist nur noch die auf das Sinussignal zurückgehende Spektrallinie bei der Frequenz des Sinussignals und das Rauschspektrum des dem gepulsten Sinussignal überlagerten Rauschsignalanteils enthalten.

Für die Entfernung von Pulspausen aus dem komplexen gepulsten Sinussignal im Basisband sind anstelle von Ringpuffern auch andere Funktionseinheiten und andere Verfahrensmechanismen anwendbar und von der Erfindung mit abgedeckt.

Die Inphase-Komponente I’ und die Quadratur-Komponente Q’ des von Pulspausen befreiten gepulsten Sinussignals im Basisband u(t)’ bzw. u(t)" werden im nächsten Verfahrensschritt S70 einer Einheit 19 zum Ermitteln der Phase des gepulsten Sinussignals im Basisband zugeführt, die bevorzugt als Coordinate-Rotation-Digital-Computer (Cordic)-Baustein realisiert ist. Dieser Cordic-Baustein ermittelt aus den kartesischen Koordinaten - Inphase-Komponente I’ und die Quadratur-Komponente Q’ - des von Pulspausen befreiten komplexen gepulsten Sinussignals u(t)’ bzw. u(t)" im Basisband die zugehörigen Polarkoordinaten - Phase $\varphi$ und Amplitude r - des von Pulspausen befreiten komplexen gepulsten Sinussignals u(t)’ bzw. u(t)" im Basisband. Für die Ermittlung des Phasenrausch-Spektrums ist die vom Cordic-Baustein ermittelte Amplitude r des von Pulspausen befreiten komplexen gepulsten Sinussignals u(t)’ bzw. u(t)" im Basisband irrelevant und kann zur optionalen Ermittlung des Amplitudenrausch-Spektrums verwendet werden.

Im nächsten Verfahrensschritt S80 wird die ermittelte Phase $\varphi$ des von Pulspausen befreiten komplexen gepulsten Sinussignals u(t)’ bzw. u(t)" im Basisband einem Fast-Fourier-Transformator (FFT) zur Ermittlung des korrespondierenden Phasenspektrums zugeführt.

Zur Gewinnung des Phasenrausch-Spektrums des von Pulspausen befreiten komplexen gepulsten Sinussignals u(t)’ bzw. u(t)" im Basisband werden schließlich in einem abschließenden Verfahrensschritt S90 die zum sinusförmigen Nutzsignalanteil gehörigen Phasenspektralanteile, d.h. die bei der positiven und negativen Frequenz des Sinussignals jeweils befindlichen Spektrallinien, aus dem ermittelten Phasenspektrum beseitigt. Die Frequenzlage der zum Sinussignal gehörigen Spektrallinien wird bei nicht exakter und bekannter Frequenzkonstanz des Sinussignals beispielsweise mittels eines in Fig. 2 nicht dargestellten Schwellwert-Detektors identifiziert oder ist bei exakter Frequenzkonstanz des Sinussignals bereits bekannt. Die Beseitigung der Spektrallinien bei der ermittelten oder bekannten Frequenzlage erfolgt in einem Interpolator 21 mittels Interpolation der jeweils benachbarten Spektralwerte des Phasenspektrums und Ersetzen des Spektralwerts der Spektrallinie durch den ermittelten Interpolationswert.

Zusätzlich werden in diesem Verfahrensschritt S90 die bei der ersten Unterausführungsform der erfindungsgemäßen Entfernung von Pulspausen aus dem gepulsten Sinussignal u(t) im Spektrum enthaltenen Dirac-Stöße mittels Interpolation der zum jeweiligen Dirac-Stoß jeweils benachbarten Spektralwerte des Phasen-Spektrums und Ersetzen des Spektralwerts des jeweiligen Dirac-Stoßes durch den ermittelten Interpolationswert beseitigt.

Im Folgenden wird die zweite Ausführungsform der erfindungsgemäßen Vorrichtung anhand des Blockdiagramms in Fig. 2B und des erfindungsgemäßen Verfahrens anhand des Flussdiagramms in Fig. 7B erläutert:

Die ersten Verfahrensschritte S100 bis S140 der zweiten Ausführungsform des erfindungsgemäßen Verfahrens in Fig. 7B sowie die zugehörigen Funktionseinheiten der zweiten Ausführungsform der erfindungsgemäßen Vorrichtung in Fig. 2B entsprechen den Verfahrensschritten S10 bis S50 der ersten Ausführungsform des erfindungsgemäßen Verfahrens in Fig. 7A und den zugehörigen Funktionseinheiten der ersten Ausführungsform der erfindungsgemäßen Vorrichtung in Fig. 2A und werden somit nicht mehr beschrieben.

Im nächsten Verfahrensschritt S150 werden in einer zur Einheit 27’ zum Entfernen von Pulspausen aus dem gepulsten Sinussignal gehörigen Einheit 22 zum Nullsetzen von Signalpegeln in Pulspausen die in den Pulspausen auftretenden Abtastwerte, die aufgrund eines auftretenden Rauschens nicht verschwinden, zu Null gesetzt. Der Beginn und das Ende der einzelnen Pulspausen des komplexen digitalen gepulsten Sinussignals im Basisbands kann äquivalent wie in der ersten Ausführungsform der Erfindung mittels Schwellwertvergleich der Abtastwerte des komplexen digitalen gepulsten Sinussignals mit einem geeignet gewählten Schwellwert ermittelt werden.

Im darauffolgenden Verfahrensschritt S151 werden von einer zur Einheit 27’ zum Entfernen von Pulspausen aus dem gepulsten Sinussignal gehörigen Einheit 26 zur Steuerung des Phasenschiebers die Erwartungswerte für den Beginn jedes zeitlich zu verschiebenden Pulses des komplexen gepulsten Sinussignals im Basisband ermittelt und darauf aufbauend das Verschiebungszeitintervall jedes einzelnen zu verschiebenden Pulses zum neuen Pulsbeginn nach der zeitlichen Verschiebung bestimmt.

Auf der Basis der ermittelten Erwartungswerte für den Pulsbeginn jedes einzelnen zu verschiebenden Pulses werden im nächsten Verfahrensschritt S152 von einem nachfolgenden, zur Einheit 27' zum Entfernen von Pulspausen aus dem gepulsten Sinussignal gehörigen Fast-Fourier-Transformator 23 bzw. von jedem anderen geeigneten Spektral-Transformator für jeden einzelnen Puls des digitalen komplexen gepulsten Sinussignals im Basisband jeweils die Abtastwerte des komplexen gepulsten Sinussignals im Basisband in einem Zeitintervall, das sich gemäß Fig. 2 über die gesamte Pulslänge des jeweiligen Pulses zuzüglich eines bestimmten dem jeweiligen Puls jeweils vorausgehenden und nachlaufenden Zeitintervalls (siehe gestrichelt in Fig. 3 dargestellter Zeitbereich) erstreckt, in den Spektralbereich transformiert.

Das Spektrum des jeweiligen Pulses des digitalen komplexen gepulsten Sinussignals im Basisband wird im nächsten Verfahrensschritt S153 von einem nachfolgenden, zur Einheit 27' zum Entfernen von Pulspausen aus dem gepulsten Sinussignal gehörigen Phasenschieber 24 um einen frequenzabhängigen Phasenwinkel phasenverschoben, der entsprechend dem Verschiebungssatz der Spektraltransformation gemäß der Transformationsbedingung in Gleichung (1) zum in Verfahrensschritt S151 ermittelten Verschiebungszeitintervall $T_i$ des jeweiligen Pulses *i* korrespondiert.

$$u(t-T_i) \leftrightarrow e^{-j2\pi T_i f} \cdot U(f) \qquad (1)$$

Das zu jedem einzelnen Puls des digitalen komplexen gepulsten Sinussignals im Basisband jeweils gehörige phasenverschobene Spektrum wird im darauffolgenden Verfahrensschritt S154 in einem nachfolgenden, zur Einheit 27' zum Entfernen von Pulspausen aus dem gepulsten Sinussignal gehörigen inversen Fast-Fourier-Transformator 25 zur Erzeugung eines zeitlich verschobenen Pulses in den Zeitbereich transformiert. Für die Rücktransformation in den Zeitbereich wird wiederum ein Frequenzbereich benutzt, der sich über alle Spektralwerte des zum jeweiligen Puls gehörigen Spektrums zuzüglich eines diesem Spektrum vorausgehenden und nachlaufenden Frequenzbereichs erstreckt.

Im nächsten Verfahrensschritt S155 werden die von Null verschiedenen Abtastwerte des jeweiligen zeitlich verschobenen Pulses des digitalen komplexen gepulsten Sinussignals im Basisband aus dem ermittelten Ergebnis der Rücktransformation ausgeschnitten und sukzessive in einen zur Einheit 27' zum Entfernen von Pulspausen aus dem gepulsten Sinussignal gehörigen Ringpuffer 18 zum Zusammenfügen der Abtastwerte der einzelnen Pulse des digitalen komplexen gepulsten Sinussignals im Basisband abgespeichert.

Die letzten Verfahrensschritte S160 bis S180 der zweiten Ausführungsform des erfindungsgemäßen Verfahrens in Fig. 7B sowie die zugehörigen Funktionseinheiten der zweiten Ausführungsform der erfindungsgemäßen Vorrichtung in Fig. 2B entsprechen den Verfahrensschritten S70 bis S90 der ersten Ausführungsform des erfindungsgemäßen Verfahrens in Fig. 7A und den zugehörigen Funktionseinheiten der ersten Ausführungsform der erfindungsgemäßen Vorrichtung in Fig. 2A und werden somit auch nicht mehr beschrieben.

Im Folgenden wird die dritte Ausführungsform der erfindungsgemäßen Vorrichtung anhand des Blockdiagramms in Fig. 2C und des erfindungsgemäßen Verfahrens anhand des Flussdiagramms in Fig. 7C erläutert:

Im ersten Verfahrensschritt S200 wird analog zum Verfahrensschritt S10 der ersten Ausführungsform des erfindungsgemäßen Verfahrens ein gepulstes Sinussignal in einer Signalquelle 1 generiert. Dieses gepulste Sinussignal wird im nächsten Verfahrensschritt S210 in einem Verteiler 22' in ein erstes gepulstes Sinussignal und ein zum ersten gepulsten Sinussignal identisches zweites gepulstes Sinussignal geteilt.

Im nächsten Verfahrensschritt S220 erfolgt in Analogie zum Verfahrensschritt S20 der ersten Ausführungsform des erfindungsgemäßen Verfahrens in einem Verstärker $11_1$ eine Signalpegelanpassung des ersten gepulsten Sinussignal an den Eingangssignalpegelbereich eines nachfolgenden Analog-Digital-Wandlers $12_1$ und in einem Verstärker $11_2$ eine Signalpegelanpassung des zweiten gepulsten Sinussignal an den Eingangssignalpegelbereich eines nachfolgenden Analog-Digital-Wandlers $12_2$. Zusätzlich wird eine Tiefpassfilterung in einem Tiefpass-Filter $13_1$ für das erste gepulste Sinussignal und in einem Tiefpass-Filter $13_2$ für das zweite gepulste Sinussignal zur Vermeidung von Aliasing im zugehörigen Spektrum des digitalisierten ersten bzw. zweiten gepulsten Sinussignals nach der Analog-Digital-Wandlung durchgeführt.

Im darauffolgenden Verfahrensschritt S230 wird in Analogie zum Verfahrensschritt S30 der ersten Ausführungsform des erfindungsgemäßen Verfahrens das erste gepulste Sinussignal in einem Mischer $14_1$ mit einem in einem zugehörigen lokalen Oszillator $15_1$ generierten Mischersignal und das zweite gepulste Sinussignal in einem Mischer $14_2$ mit einem in einem zugehörigen lokalen Oszillator $15_2$ generierten Mischersignal jeweils in eine Zwischenfrequenzlage gemischt.

Im nächsten Verfahrensschritt S240 erfolgt in Analogie zum Verfahrensschritt S40 der ersten Ausführungsform des erfindungsgemäßen Verfahrens die Analog-Digital-Wandlung des ersten gepulsten Signals mittels eines Analog-Digital-Wandlers $12_1$ und die Analog-Digital-Wandlung des zweiten gepulsten Signals mittels eines Analog-Digital-Wandlers $12_2$ im Zwischenfrequenzband.

Im darauffolgenden Verfahrensschritt S250 wird in Analogie zum Verfahrensschritt S50 der ersten Ausführungsform des erfindungsgemäßen Verfahrens das digitale erste gepulste Sinussignal mittels eines Quadratur-Mischers $16_1$ und das digitale zweite gepulste Sinussignal mittels eines Quadratur-Mischers $16_2$ jeweils vom Zwischenfrequenzband ins Basisband gemischt.

Der nächste Verfahrensschritt S260 beinhaltet in Analogie zum Verfahrensschritt S60 der ersten Ausführungsform des erfindungsgemäßen Verfahrens die Entfernung von Pulspausen aus dem digitalen ersten bzw. zweiten komplexen gepulsten Sinussignal im Basisband. Hierzu werden von einer zur ersten Einheit $27_1$ zum Entfernen von Pulspausen aus dem gepulsten Sinussignal gehörigen ersten Einheit $17_1$ zum Zusammenfügen von in Pulsen auftretenden Signalwerten die Zeitintervalle der Pulspausen anhand eines Schwellwertvergleichs der Abtastwerte der Inphase- und Quadraturkomponenten des ersten komplexen gepulsten Sinussignals im Basisband mit einem geeignet gewählten Schwellwert identifiziert und einzig die in den Pulsen auftretenden Abtastwerte der Inphase- und Quadraturkomponenten des ersten komplexen gepulsten Sinussignals im Basisband in einem zur ersten Einheit $27_1$ zum Entfernen von Pulspausen aus dem gepulsten Sinussignal gehörigen ersten Ringpuffer $18_1$ abgespeichert. Analog werden von einer zur zweiten Einheit $27_2$ zum Entfernen von Pulspausen aus dem gepulsten Sinussignal gehörigen zweiten Einheit $17_2$ zum Zusammenfügen von in Pulsen auftretenden Signalwerten die Zeitintervalle der Pulspausen anhand eines Schwellwertvergleichs der Abtastwerte der Inphase- und Quadraturkomponenten des zweiten komplexen gepulsten Sinussignals im Basisband mit einem geeignet gewählten Schwellwert identifiziert und einzig die in den Pulsen auftretenden Abtastwerte der Inphase- und Quadraturkomponenten des zweiten komplexen gepulsten Sinussignals im Basisband in einem zur zweiten Einheit $27_2$ zum Entfernen von Pulspausen aus dem gepulsten Sinussignal gehörigen zweiten Ringpuffer $18_2$ abgespeichert.

Aus den kartesischen Komponenten - Inphase-Komponente $I_1$ und Quadratur-Komponente $Q_1$ - des digitalen komplexen ersten gepulsten Sinussignals werden im ersten Ringpuffer $18_1$ von Pulspausen befreite kartesische Komponenten - Inphase-Komponenten $I_1'$ und Quadratur-Komponenten $Q_1'$ - des digitalen komplexen ersten gepulsten Sinussignals erstellt. Analog werden aus den kartesischen Komponenten - Inphase-Komponente $I_2$ und Quadratur-Komponente $Q_2$ - des digitalen komplexen zweiten gepulsten Sinussignals im zweiten Ringpuffer $18_2$ von Pulspausen befreite kartesische Komponenten - Inphase-Komponenten $I_2'$ und Quadratur- Komponenten $Q_2'$ - des digitalen komplexen zweiten gepulsten Sinussignals erstellt.

Im nächsten Verfahrensschritt S270 werden in Analogie zum Verfahrensschritt S70 der ersten Ausführungsform des erfindungsgemäßen Verfahrens die Phase $\varphi_1$ des ersten komplexen gepulsten Sinussignals im Basisband in einer Einheit $19_1$ zum Ermitteln der Phase des gepulsten Sinussignals aus den zugehörigen kartesischen Komponenten - Inphase-Komponente $I_1'$ und Quadratur-Komponente $Q_1'$ - des von Pulspausen befreiten, komplexen ersten gepulsten Sinussignals und die Phase $\varphi_2$ des zweiten komplexen gepulsten Sinussignals im Basisband in einer Einheit $19_2$ zum Ermitteln der Phase des gepulsten Sinussignals aus den zugehörigen kartesischen Komponenten - Inphase-Komponente $I_2'$ und Quadratur-Komponente $Q_2'$ - des von Pulspausen befreiten, komplexen zweiten gepulsten Sinussignals ermittelt.

Im darauffolgenden Verfahrensschritt S280 wird die im vorherigen Verfahrensschritt S270 ermittelte Phase $\varphi_1$ des von Pulspausen befreiten, ersten komplexen gepulsten Sinussignals mit der Phase $\varphi_2$ des von Pulspausen befreiten, zweiten komplexen gepulsten Sinussignals im Basisband in einem Kreuz-Korrelator 23' kreuzkorreliert. Im Ergebnis der Kreuz-Korrelation treten die zueinander nicht kohärenten Rauschsignalanteile, die in den beiden Messsignal-Pfaden vom Verteiler 22 bis zu den Einheiten $19_1$ bzw. $19_2$ zum Ermitteln der Phase des gepulsten Sinussignals erzeugt werden und dem ersten bzw. zweiten gepulsten Sinussignal zusätzlich überlagert sind und diese nachteilig verunreinigen, nicht mehr auf.

Im nächsten Verfahrensschritt S290 wird das Phasenspektrum des digitalen gepulsten Sinussignals im Basisband mittels Fourier-Transformation des Korrelations-Ergebnisses in einem Fast-Fourier-Transformator 20 ermittelt.

Im abschließenden Verfahrensschritt S300 werden in Analogie zum Verfahrensschritt S90 der ersten Ausführungsform des erfindungsgemäßen Verfahrens aus dem ermittelten Phasen-Spektrum die zum sinusförmigen Nutzsignalanteil gehörigen Spektrallinien und die Dirac-Stöße, die aus den Unstetigkeiten im von Pulspausen befreiten Signalverlauf des ersten bzw. zweiten komplexen gepulsten Sinussignals resultieren, in einem Interpolator 21 zur Bestimmung des reinen Phasenrausch-Spektrums des gepulsten Sinussignals beseitigt.

Die Erfindung ist nicht auf die dargestellten Ausführungsformen und Unterausführungsformen beschränkt. Insbesondere ist eine Kombination der zweiten und dritten Ausführungsform von der Erfindung mit abgedeckt, bei der in einem Kreuzkorrelator die Entfernung von Pulspausen aus dem gepulsten Sinussignals mittels Phasenverschiebung der zu den einzelnen Pulsen des gepulsten Sinussignals jeweils gehörigen Spektren erfolgt.

## Patentansprüche

1. Verfahren zur Messung des Phasenrausch-Spektrums eines gepulsten Sinussignals mit folgenden Verfahrensschritten:

Erzeugen (S10-S40) eines gepulsten digitalen Sinussignals,
Quadratur-Mischen (S50) des gepulsten Sinussignals ins Basisband,
Ermitteln der Phase des gepulsten Sinussignals im Basisband,
Ermitteln des Phasenspektrums (S80) des gepulsten Sinussignals mittels Fourier-Transformation der Phase des gepulsten Sinussignals im Basisband,
Ermitteln des Phasenrausch-Spektrums (S90) des gepulsten Sinussignals durch Beseitigung der zum Sinussignal gehörigen Spektrallinien aus den Phasenspektrum,

wobei auch die Pulspausen aus dem gepulsten Sinussignal im Basisband entfernt werden.

**2.** Verfahren nach Anspruch 1,
**dadurch gekennzeichnet,**
**dass** das Entfernen von Pulspausen aus dem gepulsten Sinussignal mittels Ausblenden der Pulspausen aus dem gepulsten Sinussignal im Zeitbereich erfolgt.

**3.** Verfahren nach Anspruch 1,
**dadurch gekennzeichnet,**
**dass** das Entfernen von Pulspausen aus dem gepulsten Sinussignal folgende iterativ durchzuführende Verfahrensschritte beinhaltet:

Nullsetzen von Signalwerten in den Pulspausen des gepulsten Sinussignals,
Ermittlung eines Erwartungswertes für den Pulsbeginn und eines Verschiebungszeitintervalls für jeden zeitlich zu verschiebenden Puls des gepulsten Sinussignals,
Ermitteln eines zu jedem Puls gehörigen Spektrums,
Verschieben der Phase des jeweiligen Spektrums korrespondierend dem Verschiebungszeitintervall des jeweiligen Pulses und
Ermitteln des jeweiligen zeitverschobenen Pulses mittels inversen Fourier-Transformieren des zum jeweiligen Puls gehörigen phasenverschobenen Spektrums und
Zwischenspeichern des jeweiligen zeitverschobenen Pulses.

**4.** Verfahren nach einem der Ansprüche 1 bis 3,
**dadurch gekennzeichnet,**
**dass** das erzeugte gepulste Sinussignal in ein erstes gepulstes Sinussignal und ein zum ersten gepulsten Sinussignal identisches zweites gepulstes Sinussignal geteilt wird, die Verfahrensschritte des Quadratur-Mischens, des Entfernens der Pulspausen, und des Ermittelns der Phase jeweils getrennt für das erste und zweite gepulste Sinussignal durchgeführt werden und das Phasenspektrum des gepulsten Sinussignals mittels Kreuzkorrelieren und anschließender Fourier-Transformation der Phase des ersten und zweiten gepulsten Sinussignals im Basisband ermittelt wird.

**5.** Verfahren nach einem der Ansprüche 1 bis 4,
**dadurch gekennzeichnet,**
**dass** im Phasenrausch-Spektrum auftretende Dirac-Impulse, die aus Unstetigkeiten im Verlauf der Phase des von Pulspausen befreiten gepulsten Sinussignals bzw. des von Pulspausen befreiten ersten gepulsten Sinussignals oder des von Pulspausen befreiten zweiten gepulsten Sinussignals resultieren, identifiziert und mittels Interpolation mit benachbarten Spektralwerten des Phasenrausch-Spektrums aus dem Phasenrausch-Spektrum beseitigt werden.

**6.** Verfahren nach einem der Ansprüche 1 bis 4,
**dadurch gekennzeichnet,**
**dass** eine Unstetigkeit, die im Verlauf der Phase des von Pulspausen befreiten gepulsten Sinussignals bzw. des von Pulspausen befreiten ersten gepulsten Sinussignals oder des von Pulspausen befreiten zweiten gepulsten Sinussignals auftritt, beseitigt wird, indem der jeweilig nachfolgende Puls des gepulsten Sinussignals oder des ersten gepulsten Sinussignals oder des zweiten gepulsten Sinussignals soweit verkürzt wird, bis die Phase im jeweilig vorausgehenden Puls des gepulsten Sinussignals bzw. des ersten gepulsten Sinussignals bzw. des zweiten gepulsten Sinussignals der Phase im jeweilig nachfolgenden Puls des gepulsten Sinussignal bzw. des ersten gepulsten Sinussignals bzw. des zweiten gepulsten Sinussignals entspricht.

**7.** Vorrichtung zur Messung des Phasenrausch-Spektrums eines gepulsten Sinussignals mit

einer Signalquelle (1) zur Erzeugung des gepulsten Sinussignals,
mindestens einem Analog-Digital-Wandler ($12;12_1,12_2$) zum Analog-Digital-Wandeln des gepulsten Sinussignals,
mindestens einem Quadratur-Mischer ($16;16_1,16_2$) zum Quadratur-Mischen des gepulsten Sinussignals ins Basisband,
mindestens einer Einheit ($19;19_1,19_2$) zum Ermitteln der Phase des gepulsten Sinussignals,
einem Fourier-Transformator (20) zum Ermitteln des Phasen-Spektrums des gepulsten Sinussignals aus der Phase des gepulsten Sinussignals,
einem Interpolator (21) zum Ermitteln des Phasenrausch-Spektrums des gepulsten Sinussignals durch Ausblenden von zum Sinussignal gehörigen Spektrallinien aus dem Phasen-Spektrum,
wobei vor dem Fourier-Transformator eine Einheit ($27;27';27_1,27_2$) zum Entfernen von Pulspausen aus dem gepulsten Sinussignal angeordnet ist.

**8.** Vorrichtung nach Anspruch 7,
**dadurch gekennzeichnet,**
**dass** die Einheit ($27;27_1,27_2$) zum Entfernen von Pulspausen aus dem gepulsten Sinussignal einen Ringpuffer ($16; 16_1, 16_2$) aufweist.

**9.** Vorrichtung nach Anspruch 8,
**dadurch gekennzeichnet,**
**dass** mit dem Ringpuffer ($16;16_1,16_2$) eine Einheit ($17;17_1,17_2$) zum Zusammenfügen von in Pulsen auftretenden Signalwerten verbunden ist.

**10.** Vorrichtung nach Anspruch 7,
**dadurch gekennzeichnet,**
**dass** die Einheit (27') zum Entfernen von Pulspausen aus dem gepulsten Sinussignal eine Einheit (22) zum Nullsetzen von in Pulspausen auftretenden Signalwerten, eine Einheit (26) zur Steuerung eines Phasenschiebers, einen Fourier-Transformator (23) zum Ermitteln des zu jedem Puls gehörigen Spektrums, einen Phasenschieber (24) zum Verschieben der Phase des jeweiligen Spektrums, einen inversen Fourier-Transformator (25) zum Ermitteln des zum jeweiligen phasenverschobenen Spektrum gehörigen zeitverschobenen Pulses und einen Ringpuffer (18) zum Speichern der einzelnen zeitverschobenen Pulse aufweist.

**11.** Vorrichtung nach einem der Ansprüche 7 bis 10, mit zwei Analog-Digital-Wandlern ($12_1$, $12_2$) und zwei Einheiten ($19_1$, $19_2$) zum Ermitteln der Phase,
**dadurch gekennzeichnet,**
**dass** zwischen der Signalquelle (1) und den beiden Analog-Digital-Wandlern ($12_1,12_2$) ein Verteiler (22) und zwischen den beiden Einheiten ($19_1,19_2$) zum Ermitteln der Phase und dem Fourier-Transformator (20) ein Kreuz-Korrelator (23) geschaltet ist.

**12.** Vorrichtung nach einem der Ansprüche 7 bis 11,
**dadurch gekennzeichnet,**
**dass** der Interpolator (21) zusätzlich zum Ausblenden von Dirac-Stößen im Phasenrausch-Spektrum dient.

## Claims

**1.** Method for measuring the phase noise spectrum of a pulsed sinusoidal signal with the following method steps:

generation (S10-S40) of a pulsed sinusoidal signal,
quadrature-mixing (S50) of the pulsed sinusoidal signal into the base band,
determination of the phase of the pulsed sinusoidal signal in the base band,
determination of the phase spectrum (S80) of the pulsed sinusoidal signal by means of Fourier transformation of the phase of the pulsed sinusoidal signal in the base band,
determination of the phase noise spectrum (S90) of the pulsed sinusoidal signal by removing the spectral lines belonging to the sinusoidal signal from the phase spectrum,
wherein the pulse pauses are also removed from the pulsed sinusoidal signal in the base band.

**2.** Method according to claim 1,
**characterised in that**

the removal of pulse pauses from the pulsed sinusoidal signal is effected by masking out the pulse pauses from the pulsed sinusoidal signal in the time domain.

**3.** Method according to claim 1,
**characterised in that**
the removal of pulse pauses from the pulsed sinusoidal signal comprises the following method steps to be carried out iteratively:

zeroing of signal values in the pulse pauses of the pulses sinusoidal signal,
determination of an expected value for the beginning of the pulse and a shift time interval for each pulse to be time-shifted in the pulsed sinusoidal signal,
determination of a spectrum belonging to each pulse,
shifting of the phase of the respective spectrum corresponding to the shift time interval of the respective pulse and determination of the respective time-shifted pulse by means of inverse Fourier transformation of the phase-shifted spectrum belonging to the respective pulse and temporary storage of the respective time-shifted pulse.

**4.** Method according to one of claims 1 to 3,
**characterised in that**
the pulsed sinusoidal signal generated is divided into a first pulsed sinusoidal signal and a second pulsed sinusoidal signal identical to the first pulsed sinusoidal signal, the method steps of quadrature mixing, removal of the pulse pauses, and determination of the phase are in each case carried out separately for the first and the second pulsed sinusoidal signal and the phase spectrum of the pulsed sinusoidal signal is determined by means of cross-correlation and subsequent Fourier transformation of the phase of the first and second pulsed sinusoidal signal in the base band.

**5.** Method according to one of claims 1 to 4,
**characterised in that**
Dirac pulses which occur in the phase noise spectrum and are the result of discontinuities in the course of the phase of the pulsed sinusoidal signal freed of pulse pauses or of the first pulsed sinusoidal signal freed of pulse pauses or the second pulsed sinusoidal signal freed of pulse pauses, respectively, are identified and removed from the phase noise spectrum by means of interpolation with neighbouring spectral values of the phase noise spectrum.

**6.** Method according to one of claims 1 to 4,
**characterised in that**
an unsteadiness/discontinuity which occurs in the course of the phase of the pulsed sinusoidal signal freed of pulse pauses or of the first pulsed sinusoidal signal freed of pulse pauses or the second pulsed sinusoidal signal freed of pulse pauses, respectively, is removed **in that** the respective following pulse of the pulsed sinusoidal signal or of the first pulsed sinusoidal signal or the second pulsed sinusoid signal is shortened until the phase in the respective preceding pulse of the pulsed sinusoidal signal or of the first pulsed sinusoidal signal or the second pulsed sinusoidal signal corresponds to the phase in the respective following pulse of the pulsed sinusoidal signal or of the first pulsed sinusoidal signal or the second pulsed sinusoidal signal, respectively.

**7.** Device for measuring the phase noise spectrum of a pulsed sinusoidal signal with
a signal source (1) for generation of the pulsed sinusoidal signal,
at least one analogue-digital converter (12; $12_1$, $12_2$) for analogue-digital conversion of the pulsed sinusoidal signal,
at least one quadrature-mixer (16; $16_1$, $16_2$) for quadrature-mixing of the pulsed sinusoidal signal into the base band,
at least one unit (19; $19_1$, $19_2$) for determining the phase of the pulsed sinusoidal signal,
a Fourier transformer (20) for determining the phase spectrum of the pulsed sinusoidal signal from the phase of the pulsed sinusoidal signal,
an interpolator (21) for determining the phase noise spectrum of the pulsed sinusoidal signal by masking out spectral lines belonging to the sinusoidal signal from the phase spectrum,
wherein a unit (27; 27'; $27_1$, $27_2$) for removing pulse pauses from the pulsed sinusoidal signal is arranged in front of the Fourier transformer.

**8.** Device according to claim 7,
**characterised in that**
the unit (27; $27_1$, $27_2$) for removing pulse paused from the pulsed sinusoidal signal exhibits a ring buffer (16; $16_1$, $16_2$).

**9.** Device according to claim 8,

**characterised in that**
a unit (17; $17_1$, $17_2$) for adding together signal values occurring in pulses is connected with the ring buffer (16; $16_1$, $16_2$).

**10.** Device according to claim 7,
**characterised in that**
the unit (27') for removing pulse pauses from the pulsed sinusoidal signal exhibits a unit (22) for zeroing signal values occurring in pulse pauses, a unit (26) for controlling a phase shifter, a Fourier transformer (23) for determining the spectrum belonging to each pulse, a phase shifter (24) for shifting the phase of the respective spectrum, an inverse Fourier transformer (25) for determining the time-shifted pulse belonging to the respective phase-shifted spectrum, and a ring buffer (18) for storing the individual time-shifted pulses.

**11.** Device according to one of claims 7 to 10, with two analogue-digital converters ($12_1$, $12_2$) and two units ($19_1$, $19_2$) for determining the phase,
**characterised in that**
connected between the signal source (1) and the two analogue-digital converters ($12_1$, $12_2$) there is a distributor (22) and connected between the two units ($19_1$, $19_2$) for determining the phase and the Fourier transformer (20) there is a cross-correlator (23).

**12.** Device according to one of claims 7 to 11,
**characterised in that**
the interpolator (21) additionally serves to mask out Dirac pulse functions in the phase noise spectrum.

## Revendications

**1.** Procédé pour mesurer le spectre de bruit de phase d'un signal sinusoïdal pulsé comportant les étapes de procédé suivantes :

la génération (S10-S40) d'un signal sinusoïdal numérique pulsé,
le mélange en quadrature (S50) du signal sinusoïdal pulsé en bande de base,
la détection de la phase du signal sinusoïdal pulsé en bande de base,
la détection du spectre de phase (S80) du signal sinusoïdal pulsé au moyen d'une transformation de Fourier de la phase du signal sinusoïdal pulsé en bande de base,
la détection du spectre de bruit de phase (S90) du signal sinusoïdal pulsé par suppression des lignes spectrales appartenant au signal sinusoïdal du spectre de phase,
dans lequel les pauses d'impulsion provenant du signal sinusoïdal pulsé en bande de base sont également éliminées.

**2.** Procédé selon la revendication 1, **caractérisé en ce que**
l'élimination des pauses d'impulsion provenant du signal sinusoïdal pulsé est effectuée dans le domaine temporel au moyen du masquage des pauses d'impulsion provenant du signal sinusoïdal pulsé.

**3.** Procédé selon la revendication 1, **caractérisé en ce que**
l'élimination des pauses d'impulsion provenant du signal sinusoïdal pulsé comporte les étapes de procédé suivantes à effectuer de manière itérative :

la réinitialisation des valeurs de signal dans les pauses d'impulsion du signal sinusoïdal pulsé,
la détection d'une valeur de maintenance pour le début d'impulsion et un intervalle de temps de décalage pour chaque impulsion à décaler temporellement du signal sinusoïdal pulsé,
la détection d'un spectre appartenant à chaque impulsion,
le décalage de la phase du spectre respectif correspondant à l'intervalle de temps de décalage de l'impulsion respective et
la détection de l'impulsion respective décalée dans le temps au moyen d'une transformée de Fourier inverse du spectre décalé en phase appartenant à l'impulsion respective et
la mise en mémoire de l'impulsion respective décalée dans le temps.

**4.** Procédé selon l'une des revendications 1 à 3, **caractérisé en ce que**
le signal sinusoïdal pulsé généré est divisé en un premier signal sinusoïdal pulsé et un second signal sinusoïdal pulsé identique au premier signal sinusoïdal pulsé, l'étape de procédé du mélange en quadrature, de l'élimination des pauses d'impulsion, et de la détection de la phase sont effectuées de manière respectivement séparée pour le premier et le second signal sinusoïdal pulsé et le spectre de phase du signal sinusoïdal pulsé est détecté au moyen d'une corrélation croisée et ensuite par une transformation de Fourier de la phase du premier et du second signal sinusoïdal pulsé en bande de base.

5. Procédé selon l'une des revendications 1 à 4, **caractérisé en ce que** des impulsions de Dirac apparaissant dans le spectre de bruit de phase, qui résultent des discontinuités dans le tracé de la phase du signal sinusoïdal pulsé sans pauses d'impulsion ou du premier signal sinusoïdal pulsé sans pauses d'impulsion ou du second signal sinusoïdal pulsé sans pauses d'impulsion, sont identifiées et éliminées au moyen d'une interpolation avec des valeurs spectrales voisines du spectre de bruit de phase à partir du spectre de bruit de phase.

6. Procédé selon l'une des revendications 1 à 4, **caractérisé en ce que** une discontinuité qui apparaît dans le tracé de la phase du signal sinusoïdal pulsé sans pauses d'impulsion ou du premier signal sinusoïdal pulsé sans pauses d'impulsion ou du second signal sinusoïdal pulsé sans pauses d'impulsion, est éliminée, tandis que l'impulsion suivante respective du signal sinusoïdal pulsé ou du premier signal sinusoïdal pulsé ou du second signal sinusoïdal pulsé est raccourcie de sorte que la phase de l'impulsion sortante respective du signal sinusoïdal pulsé ou du premier signal sinusoïdal pulsé ou du second signal sinusoïdal pulsé correspond à la phase de l'impulsion suivante respective du signal sinusoïdal pulsé ou du premier signal sinusoïdal pulsé ou du second signal sinusoïdal pulsé.

7. Dispositif de mesure du spectre de bruit de phase d'un signal sinusoïdal pulsé comportant
une source de signal (1) pour générer le signal sinusoïdal pulsé,
au moins un convertisseur analogique-numérique (12 ; $12_1$, $12_2$) pour convertir de manière analogique-numérique le signal sinusoïdal pulsé,
au moins un mélangeur en quadrature (16 ; $16_1$, $16_2$) pour mélanger en quadrature le signal sinusoïdal pulsé en bande de base,
au moins une unité (19 ; $19_1$, $19_2$) pour détecter la phase du signal sinusoïdal pulsé,
un transformateur de Fourier (20) pour détecter le spectre de phase du signal sinusoïdal pulsé à partir de la phase du signe signal sinusoïdal pulsé,
un interpolateur (21) pour détecter le spectre de bruit de phase du signal sinusoïdal pulsé par masquage des lignes spectrales appartenant au signal sinusoïdal à partir du spectre de phase,
dans lequel une unité (27 ; 27' ; $27_1$, $27_2$) pour éliminer les pauses d'impulsion du signal sinusoïdal pulsé est disposée avant le transformateur de Fourier.

8. Dispositif selon la revendication 7, **caractérisé en ce que** l'unité (27 ; $27_1$, $27_2$) pour éliminer les pauses d'impulsion du signal sinusoïdal pulsé présente un tampon circulaire (16 ; $16_1$, $16_2$).

9. Dispositif selon la revendication 8, **caractérisé en ce que** une unité (17 ; $17_1$, $17_2$) pour réunir les valeurs de signal apparues dans les impulsions est reliée au tampon circulaire (16 ; $16_1$, $16_2$).

10. Dispositif selon la revendication 7, **caractérisé en ce que** l'unité (27') pour éliminer les pauses d'impulsion du signal sinusoïdal pulsé présente une unité (22) pour réinitialiser les valeurs de signal apparues pendant les pauses d'impulsion, une unité (26) pour commander un déphaseur, un transformateur de Fourier (23) pour détecter le spectre appartenant à chaque impulsion, un déphaseur (24) pour décaler la phase du spectre respectif, un transformateur de Fourier inverse (25) pour détecter l'impulsion décalée dans le temps appartenant au spectre déphasé respectif et un tampon annulaire (18) pour stocker les différentes impulsions décalées dans le temps.

11. Dispositif selon l'une des revendications 7 à 10, comportant deux convertisseurs analogiques-numériques ($12_1$, $12_2$) et deux unités ($19_1$, $19_2$) pour détecter la phase, **caractérisé en ce que** un répartiteur (22) est monté entre la source de signal (1) et les deux convertisseurs analogiques-numériques ($12_1$, $12_2$) et un corrélateur croisé (23) est monté entre les deux unités ($19_1$, $19_2$) pour détecter la phase et le transformateur de Fourier (20).

**12.** Dispositif selon l'une des revendications 7 à 11, **caractérisé en ce que** l'interpolateur (21) est utilisé en plus pour masquer les pics de Dirac dans le spectre de bruit de phase.

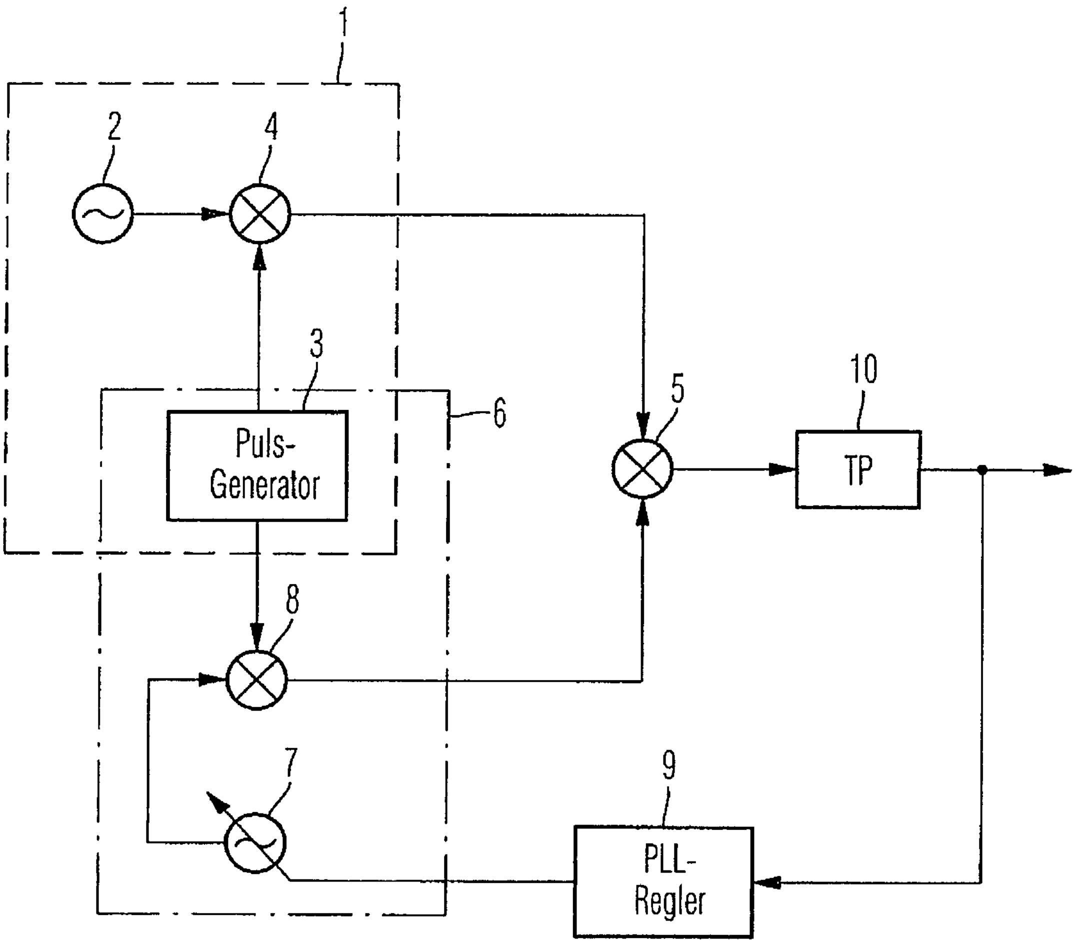


Fig. 1

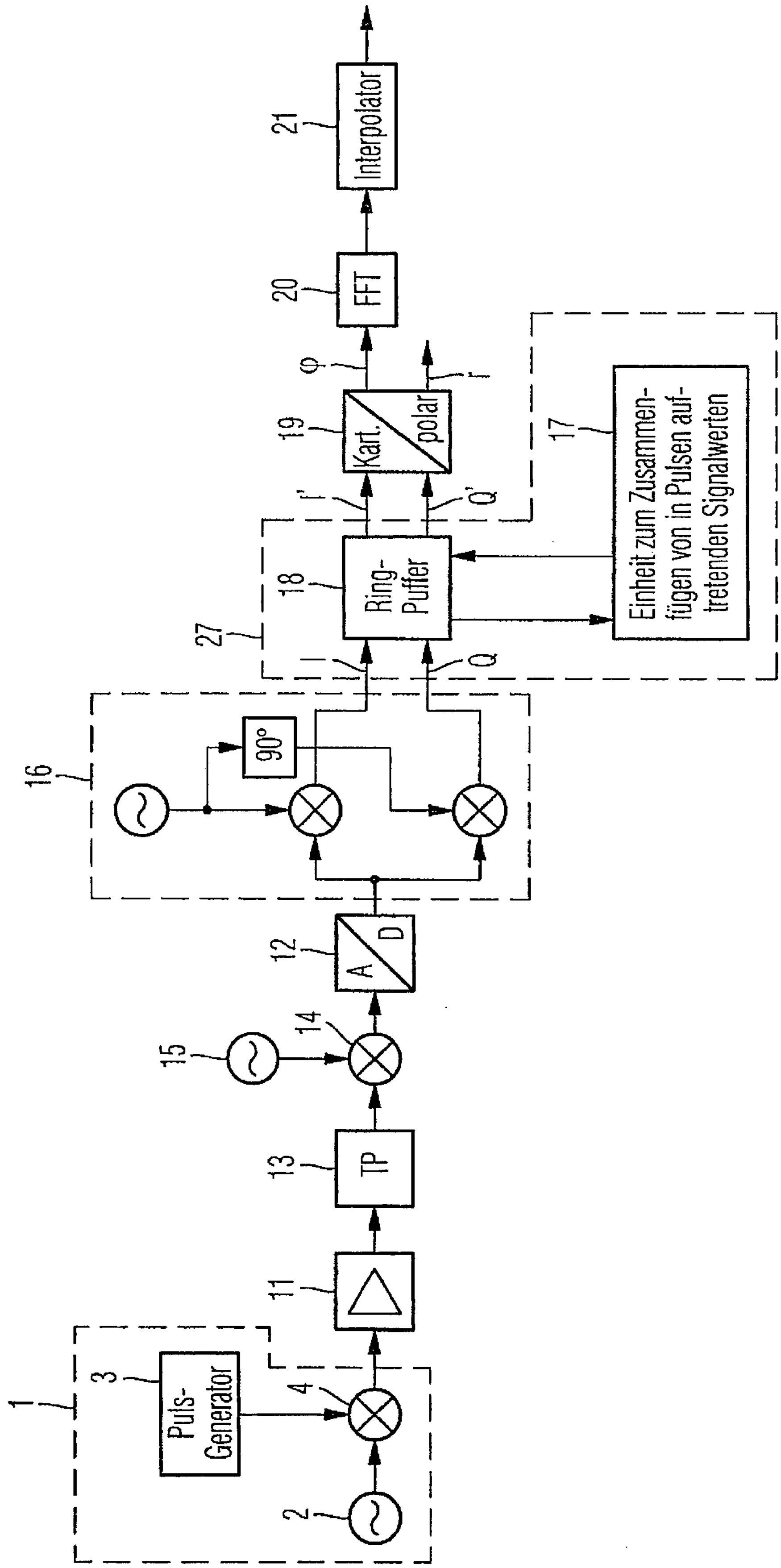
Interpolator
21
FFT
20
φ
r
Kart.
polar
19
17
I'
Q'
Einheit zum Zusammen-
fügen von in Pulsen auf-
tretenden Signalwerten
Ring-
Puffer
18
27
I
Q
90°
16
A
D
12
14
15
TP
13
11
Puls-
Generator
3
4
1
2

Fig. 2A

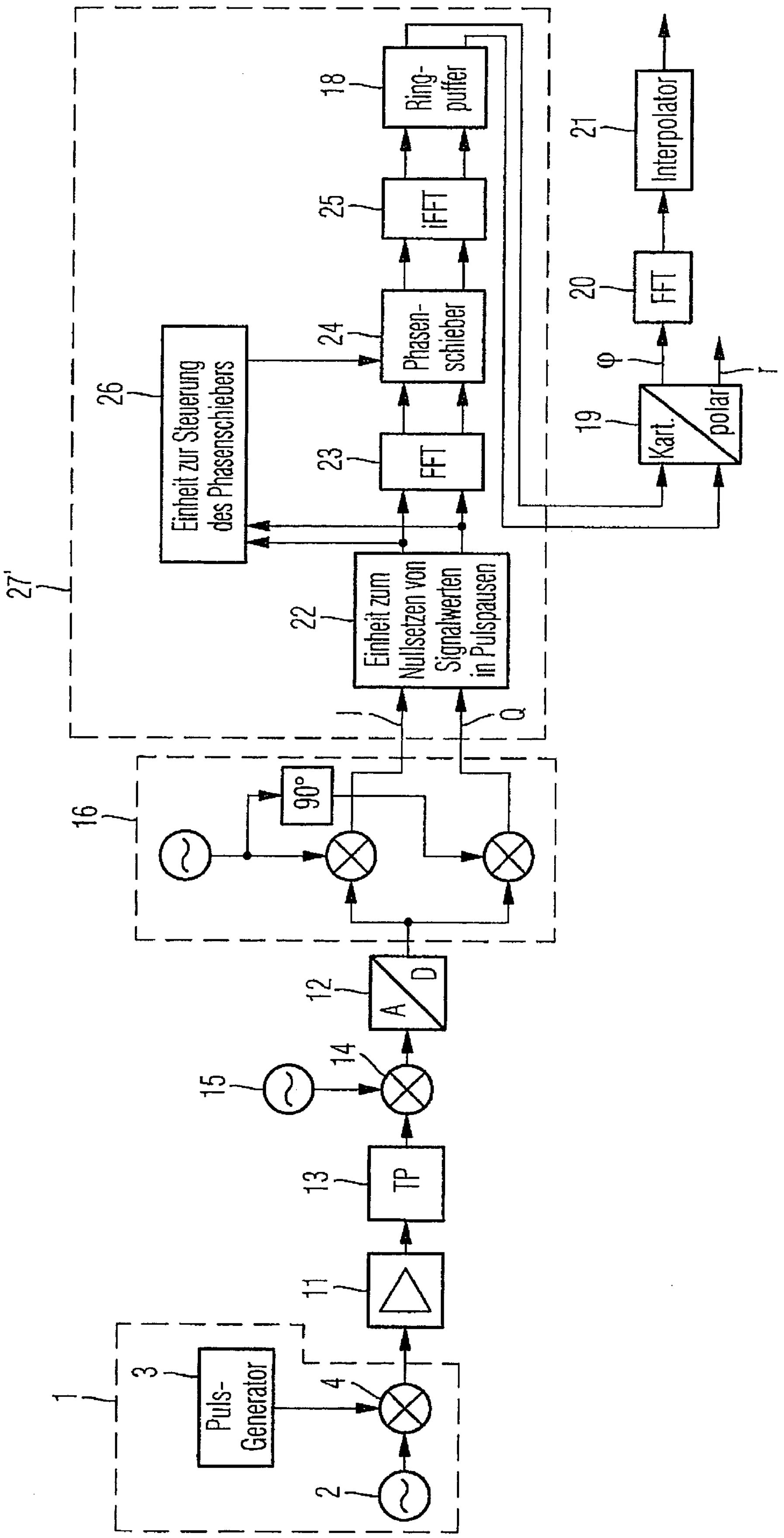
1
2
3
Puls-Generator
4
11
13
TP
14
15
12
A
D
16
90°
I
Q
27'
22
Einheit zum Nullsetzen von Signalwerten in Pulspausen
26
Einheit zur Steuerung des Phasenschiebers
23
FFT
24
Phasen-schieber
25
iFFT
18
Ring-puffer
19
Kart.
polar
φ
r
20
FFT
21
Interpolator

Fig. 2B

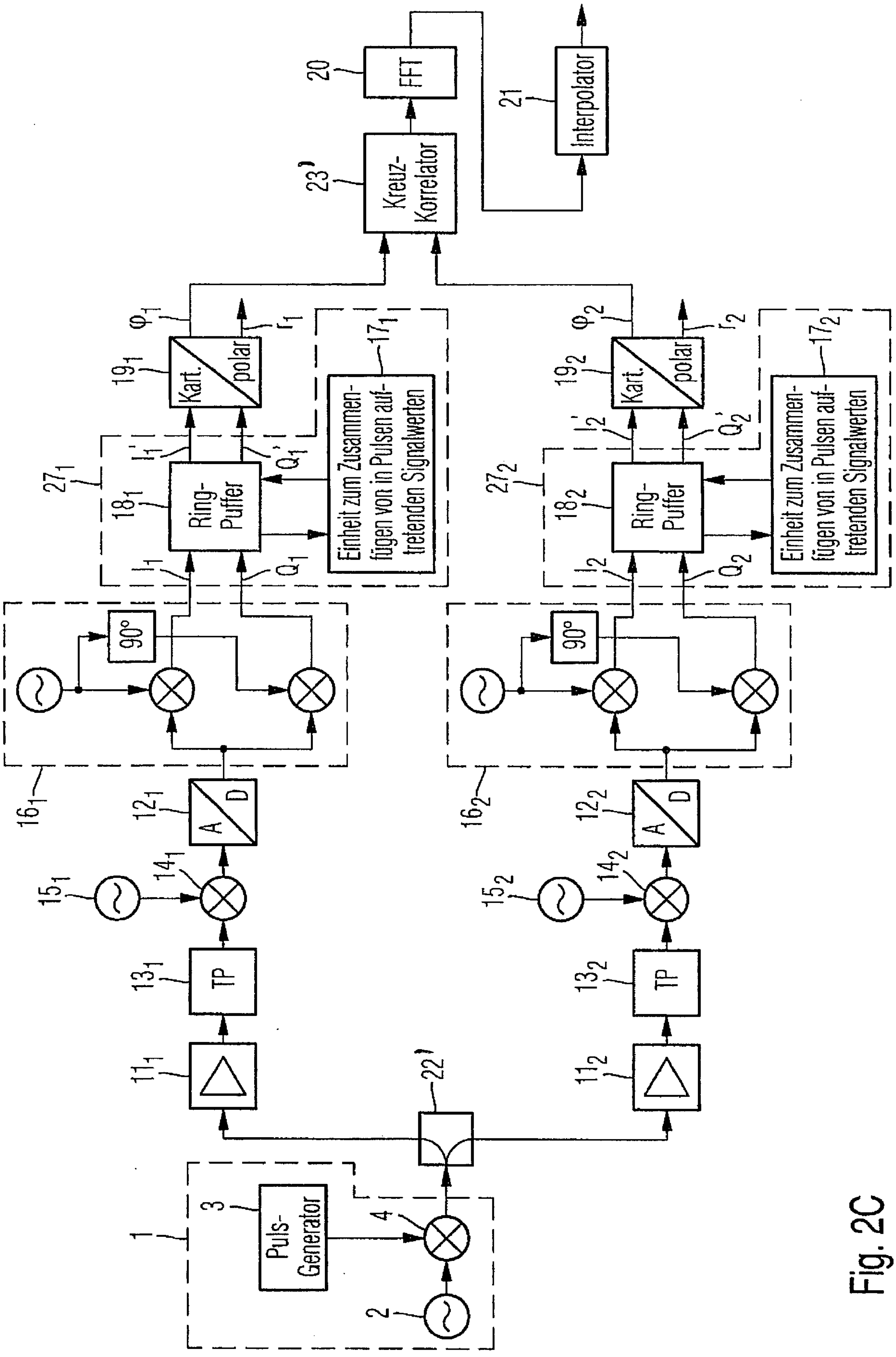
Puls-Generator
TP
A D
90°
Ring-Puffer
Einheit zum Zusammenfügen von in Pulsen auftretenden Signalwerten
Kart. polar
Kreuz-Korrelator
FFT
Interpolator

Fig. 2C

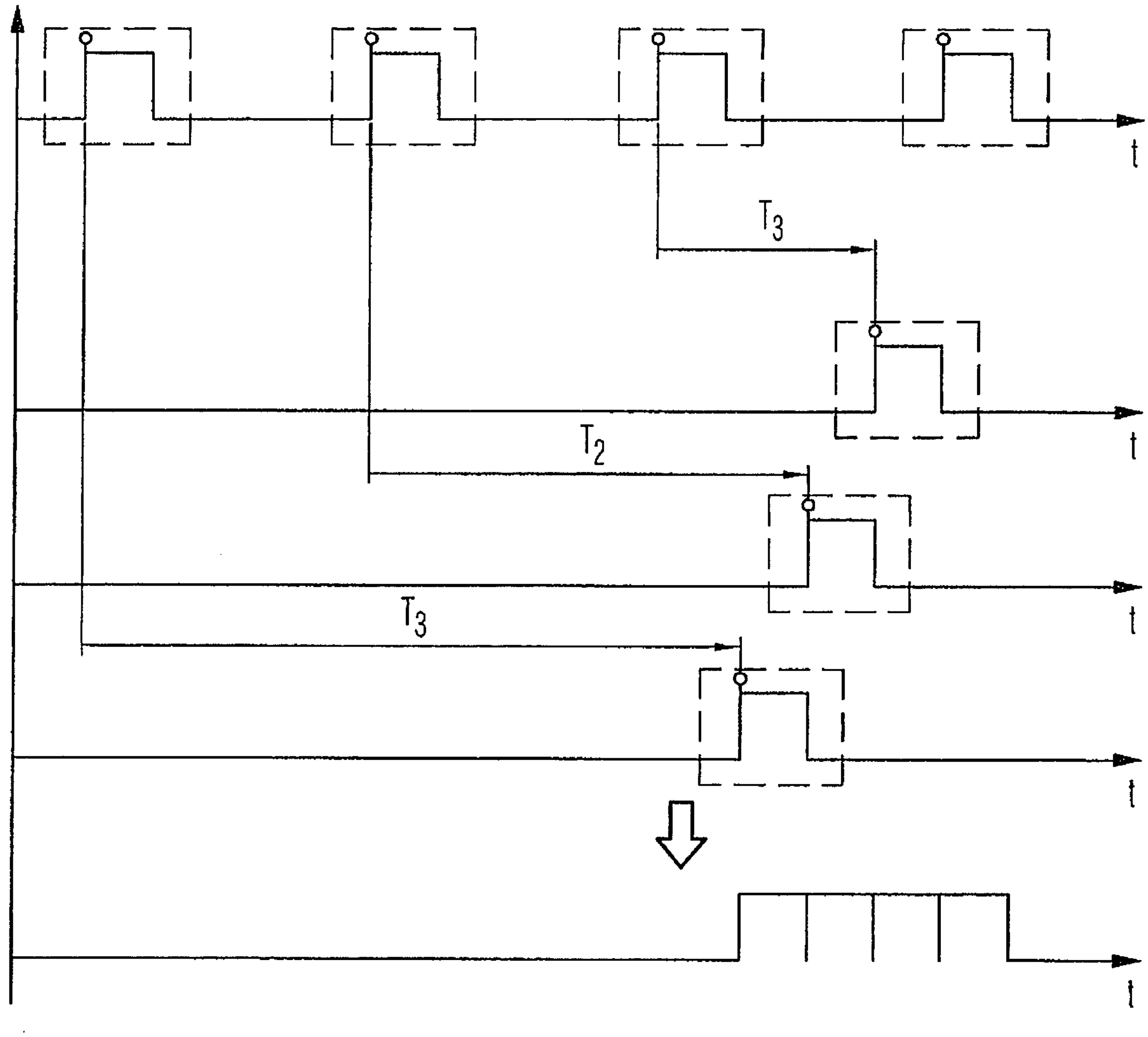


Fig. 3

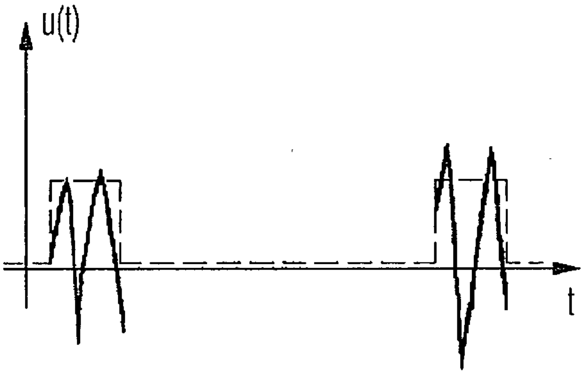


Fig. 4A

(Stand der Technik)

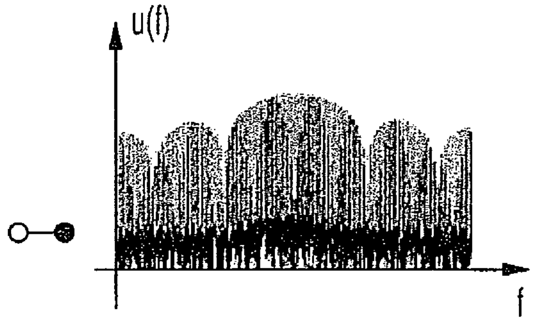


Fig. 4B

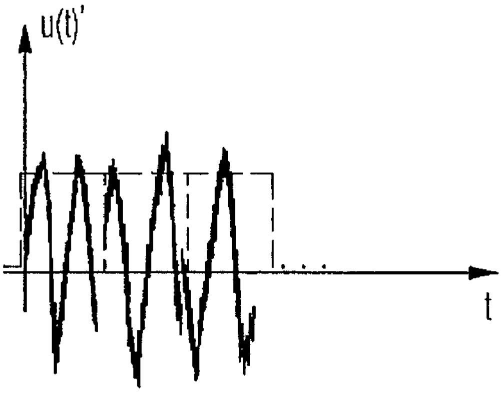


Fig. 5A

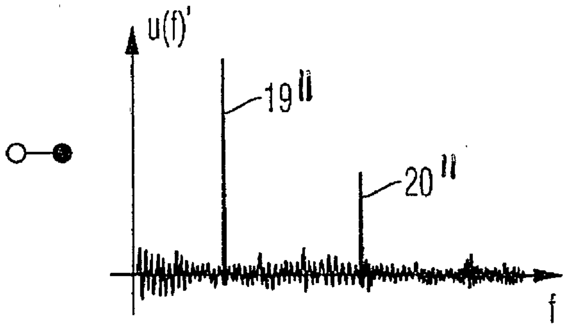


Fig. 5B

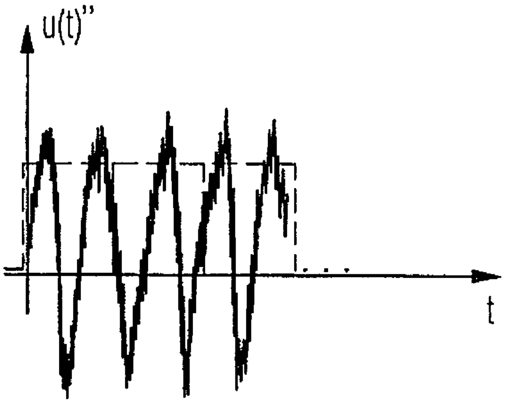


Fig. 6A

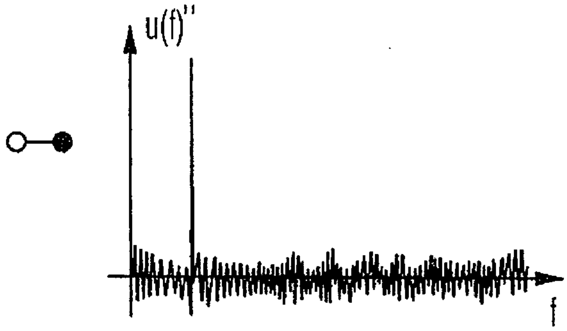


Fig. 6B

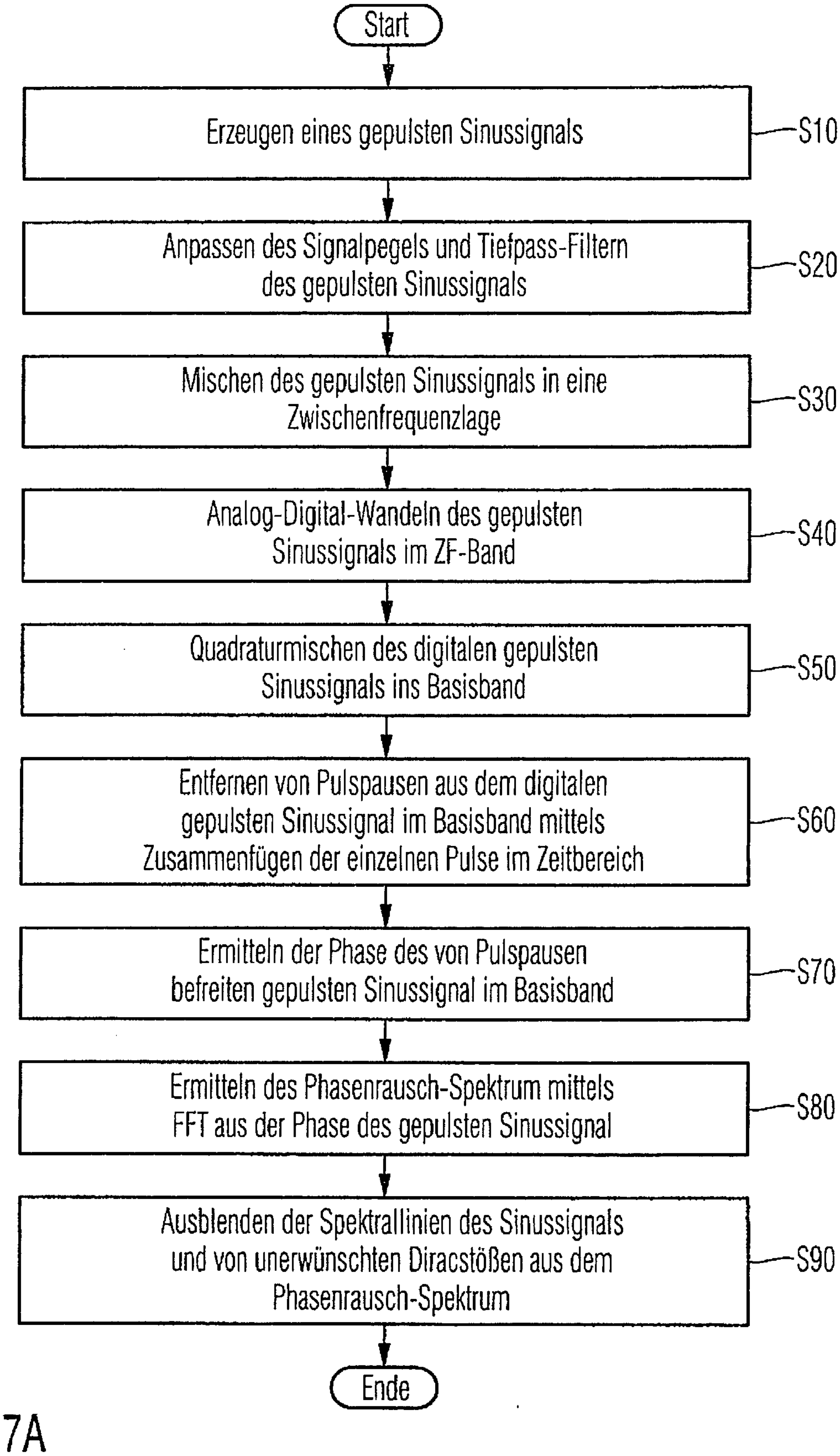
Start
Erzeugen eines gepulsten Sinussignals
S10
Anpassen des Signalpegels und Tiefpass-Filtern des gepulsten Sinussignals
S20
Mischen des gepulsten Sinussignals in eine Zwischenfrequenzlage
S30
Analog-Digital-Wandeln des gepulsten Sinussignals im ZF-Band
S40
Quadraturmischen des digitalen gepulsten Sinussignals ins Basisband
S50
Entfernen von Pulspausen aus dem digitalen gepulsten Sinussignal im Basisband mittels Zusammenfügen der einzelnen Pulse im Zeitbereich
S60
Ermitteln der Phase des von Pulspausen befreiten gepulsten Sinussignal im Basisband
S70
Ermitteln des Phasenrausch-Spektrum mittels FFT aus der Phase des gepulsten Sinussignal
S80
Ausblenden der Spektrallinien des Sinussignals und von unerwünschten Diracstößen aus dem Phasenrausch-Spektrum
S90
Ende

Fig. 7A

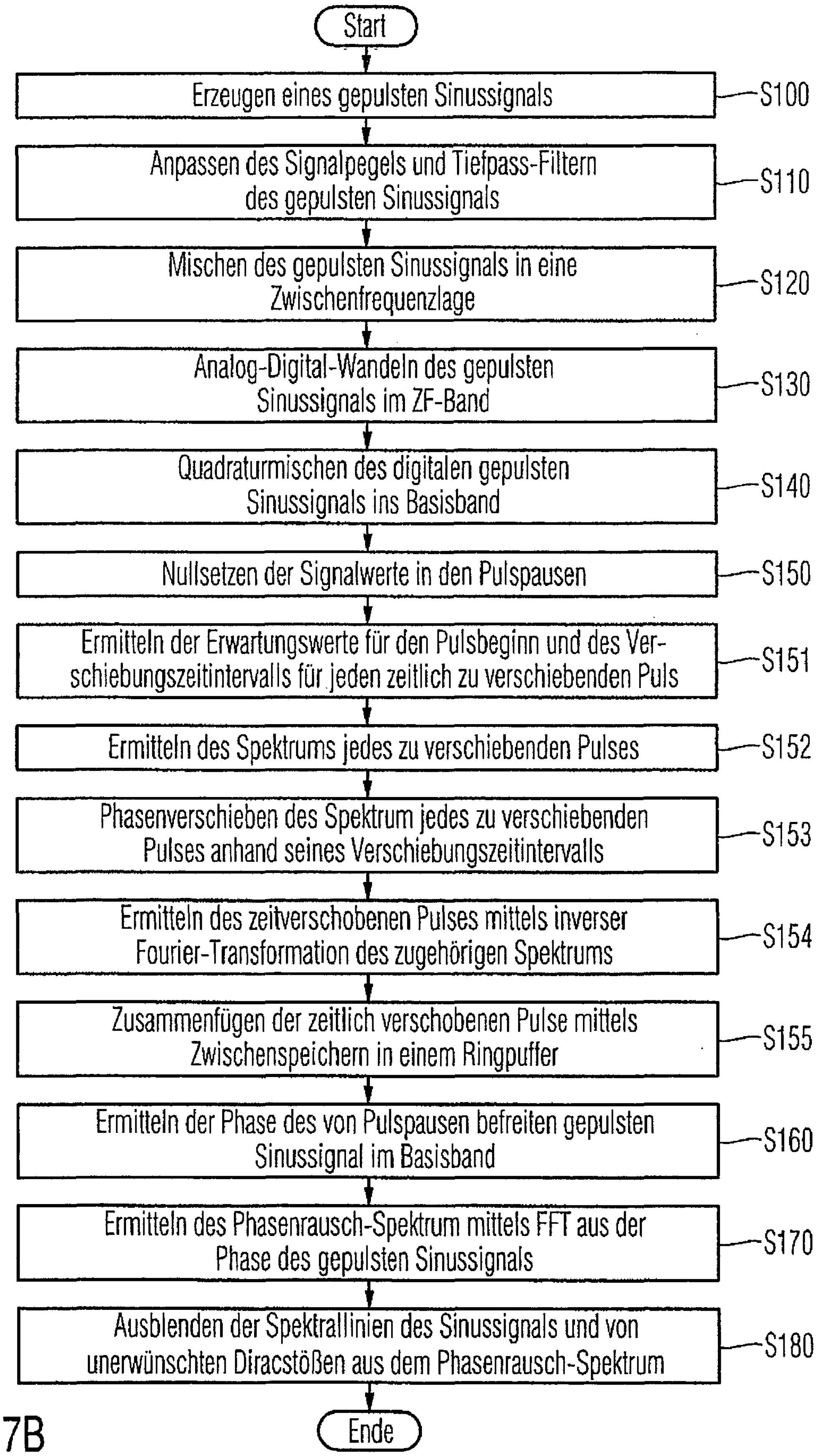
Start
Erzeugen eines gepulsten Sinussignals
S100
Anpassen des Signalpegels und Tiefpass-Filtern des gepulsten Sinussignals
S110
Mischen des gepulsten Sinussignals in eine Zwischenfrequenzlage
S120
Analog-Digital-Wandeln des gepulsten Sinussignals im ZF-Band
S130
Quadraturmischen des digitalen gepulsten Sinussignals ins Basisband
S140
Nullsetzen der Signalwerte in den Pulspausen
S150
Ermitteln der Erwartungswerte für den Pulsbeginn und des Verschiebungszeitintervalls für jeden zeitlich zu verschiebenden Puls
S151
Ermitteln des Spektrums jedes zu verschiebenden Pulses
S152
Phasenverschieben des Spektrum jedes zu verschiebenden Pulses anhand seines Verschiebungszeitintervalls
S153
Ermitteln des zeitverschobenen Pulses mittels inverser Fourier-Transformation des zugehörigen Spektrums
S154
Zusammenfügen der zeitlich verschobenen Pulse mittels Zwischenspeichern in einem Ringpuffer
S155
Ermitteln der Phase des von Pulspausen befreiten gepulsten Sinussignal im Basisband
S160
Ermitteln des Phasenrausch-Spektrum mittels FFT aus der Phase des gepulsten Sinussignals
S170
Ausblenden der Spektrallinien des Sinussignals und von unerwünschten Diracstößen aus dem Phasenrausch-Spektrum
S180
Ende

Fig. 7B

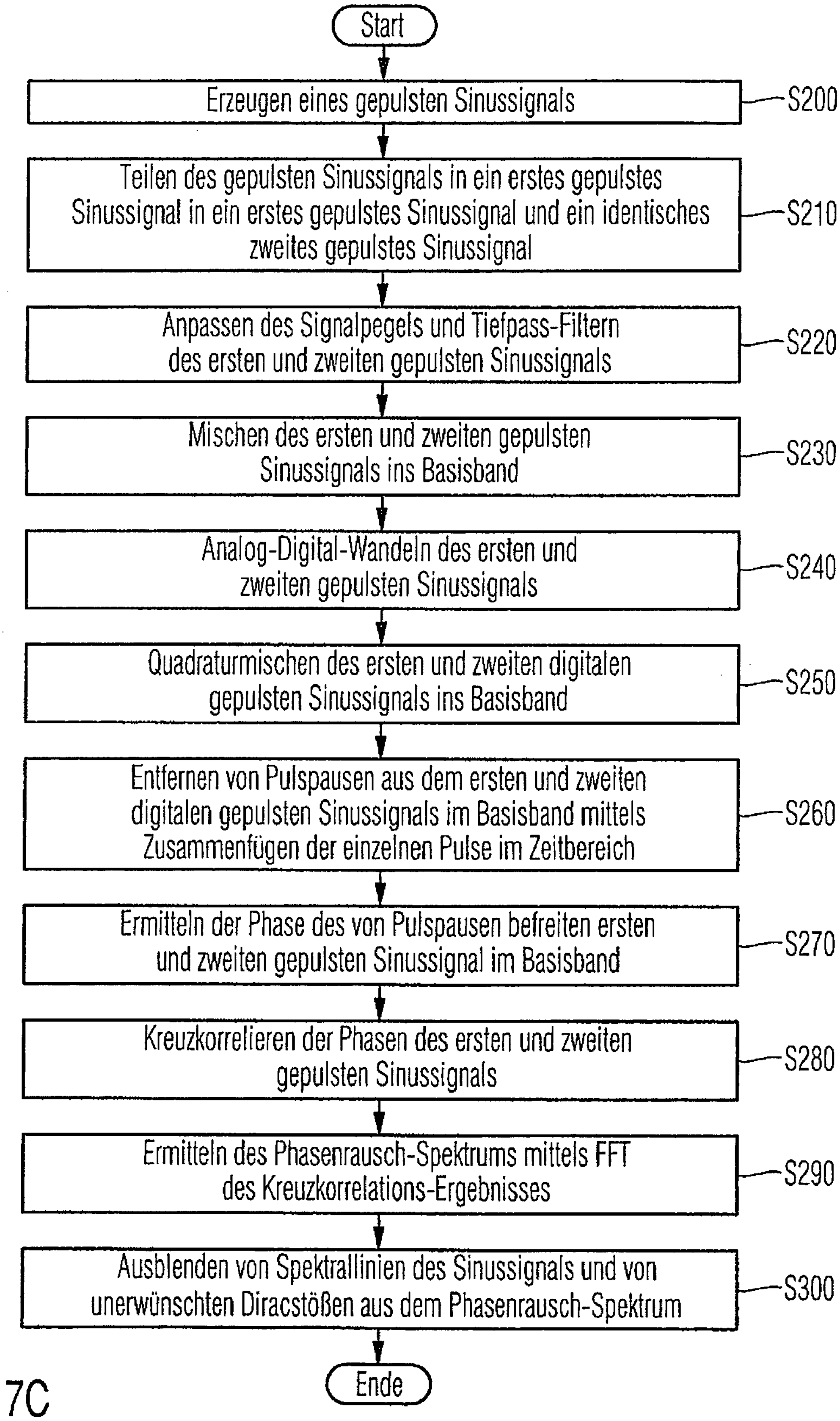
Start
Erzeugen eines gepulsten Sinussignals
S200
Teilen des gepulsten Sinussignals in ein erstes gepulstes Sinussignal in ein erstes gepulstes Sinussignal und ein identisches zweites gepulstes Sinussignal
S210
Anpassen des Signalpegels und Tiefpass-Filtern des ersten und zweiten gepulsten Sinussignals
S220
Mischen des ersten und zweiten gepulsten Sinussignals ins Basisband
S230
Analog-Digital-Wandeln des ersten und zweiten gepulsten Sinussignals
S240
Quadraturmischen des ersten und zweiten digitalen gepulsten Sinussignals ins Basisband
S250
Entfernen von Pulspausen aus dem ersten und zweiten digitalen gepulsten Sinussignals im Basisband mittels Zusammenfügen der einzelnen Pulse im Zeitbereich
S260
Ermitteln der Phase des von Pulspausen befreiten ersten und zweiten gepulsten Sinussignal im Basisband
S270
Kreuzkorrelieren der Phasen des ersten und zweiten gepulsten Sinussignals
S280
Ermitteln des Phasenrausch-Spektrums mittels FFT des Kreuzkorrelations-Ergebnisses
S290
Ausblenden von Spektrallinien des Sinussignals und von unerwünschten Diracstößen aus dem Phasenrausch-Spektrum
S300
Ende

Fig. 7C

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 102005017217 A1
- KR 20030044105 A
- US 5557196 A